(19) Europäisches Patentamt
European Patent Office
Office européen des brevets

(11) EP 4 613 460 A1

(12) EUROPEAN PATENT APPLICATION
published in accordance with Art. 153(4) EPC

(43) Date of publication:
10.09.2025 Bulletin 2025/37

(51) International Patent Classification (IPC):
**B29C 64/307** (2017.01)

(21) Application number: 23885756.9

(22) Date of filing: 31.10.2023

(52) Cooperative Patent Classification (CPC):
B29C 64/307; B29C 64/386

(86) International application number:
PCT/JP2023/039222

(87) International publication number:
WO 2024/096002 (10.05.2024 Gazette 2024/19)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(30) Priority: 31.10.2022 PCT/JP2022/040669

(71) Applicants:
• Core Concept Technologies Inc.
Tokyo 171-0022 (JP)

• Treslabo LLC.
Yokkaichi-shi, Mie 510-0076 (JP)

(72) Inventors:
• TAJIMA, Yusuke
Yokkaichi-shi, Mie 510-0076 (JP)
• Shimomura, Katsunori
Tokyo 171-0022 (JP)

(74) Representative: Müller-Boré & Partner
Patentanwälte PartG mbB
Friedenheimer Brücke 21
80639 München (DE)

(54) **METHOD AND DEVICE FOR DETERMINING DEGREE OF DETERIORATION OF SHAPING POWDER, METHOD AND DEVICE FOR PRODUCING RECLAIMED SHAPING POWDER, AND METHOD AND DEVICE FOR PRODUCING THREE-DIMENSIONAL SHAPED OBJECT**

(57) Provided are degradation-degree measuring method and measuring device for modeling powder, regenerated-modeling powder manufacturing method and manufacturing device, and three-dimensional modeled object manufacturing method and manufacturing device that can suppress the degradation of mechanical properties and dimensional accuracy of the modeled object. A pulse NMR device is used to measure the $^1$H spin-spin relaxation time T2 of a dispersion in which a modeling powder is dispersed in a solvent and calculates the specific surface area of the modeling powder based on the $^1$H spin-spin relaxation time T2 of the dispersion and the $^1$H spin-spin relaxation time T2 of the solvent. The specific surface area of the modeling powder, which appears to increase or decrease due to the heat generated by preheating in the powder bed or by the laser or electron beam irradiation, can be used as an indicator of the degradation degree of the modeling powder.

FIG.1

**Description**

TECHNICAL FIELD

This invention relates to degradation-degree measuring method and measuring device for modeling powder used in additive manufacturing using, e.g., laser or electron beam irradiation, regenerated-modeling powder manufacturing method and manufacturing device, and three-dimensional modeled object manufacturing method and manufacturing device. This application claims priority based on international application number PCT/JP2022/040669, which was filed on October 31, 2022, and this application is incorporated herein by reference.

BACKGROUND ART

Conventionally, a technology for manufacturing parts and products by additive manufacturing using powders such as resin and metal is known. For example, in the powder bed method, a layer of powder is spread out and a laser or beam is directed at it, sintering or melting the powder particles, and the process is repeated to create a modeled object through additive manufacturing. The powder bed method increases the density of the modeled object, so it is possible to obtain physical properties similar to those of conventional mass production methods (in the case of resin, injection molding, and in the case of metal, casting, and the like).

In additive manufacturing, some of the powder spread out in layers is sintered or melted using a laser or other method, so it is desirable to be able to reuse the powder that has not been sintered or melted. For example, Patent Document 1 discloses the classification of powder using a sieve mesh to reuse the powder. However, simply classifying the powder does not allow the degradation degree of the powder to be detected, and there is a risk that the mechanical properties and dimensional accuracy of the modeled object will deteriorate.

CITATION LIST

PATENT LITERATURE

Patent Document 1: JP 2008-050671 A

SUMMARY OF INVENTION

TECHNICAL PROBLEM

This technology was proposed in light of the above-mentioned conventional situation, and provides degradation-degree measuring method and measuring device for modeling powder, regenerated-modeling powder manufacturing method and manufacturing device, and three-dimensional modeled object manufacturing method and manufacturing device that can suppress the degradation of mechanical properties and dimensional accuracy of the modeled object.

SOLUTION TO PROBLEM

The present inventors have found that the specific surface area of the modeling powder, as determined by measuring the $^1$H spin-spin relaxation time T2 of the modeling powder using pulse NMR, indicates the degradation degree of the modeling powder. This is thought to be because the specific surface area of the modeling powder appears to increase or decrease due to the heat generated by preheating in the powder bed or by the laser or electron beam irradiation. Whether the specific surface area increases or decreases due to the degradation of the modeling powder depends on the type of modeling powder.

In addition, the degradation degree of the modeling powder to be inspected can be measured based on the specific surface area $S_1$ of the powder obtained by measuring the relaxation time $T2_1$ of the reference dispersion in which the reference powder is dispersed, and the specific surface area $S_2$ of the powder obtained by measuring the relaxation time $T2_2$ of the inspection dispersion in which the powder to be inspected is dispersed, that is, based on the relaxation time $T2_1$ of the reference dispersion and the relaxation time $T2_2$ of the inspection dispersion.

In order to solve the above issues, this technology provides the following degradation-degree measuring method and measuring device for modeling powder, regenerated-modeling powder manufacturing method and manufacturing device, and three-dimensional modeled object manufacturing method and manufacturing device.

[1] A degradation-degree measuring method for modeling powder that

uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder to be inspected is dispersed in the solvent and

calculates the degradation degree of the modeling powder to be inspected based on the $^1$H spin-spin relaxation time $T2_1$ of the reference dispersion and the $^1$H spin-spin relaxation time $T2_2$ of the inspection dispersion.

[2] The degradation-degree measuring method for modeling powder according to [1], wherein the modeling powder is a thermoplastic resin or a metal.

[3] The degradation-degree measuring method for modeling powder according to [1] or [2], wherein the Hansen solubility parameter of the solvent is 14 $(J/cm^3)^{1/2}$ or more and 30 $(J/cm^3)^{1/2}$ or less.

[4] A degradation-degree measuring device for modeling powder that uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder to be inspected is dispersed in the solvent and calculates the degradation degree of the modeling powder to be inspected based on the $^1$H spin-spin relaxation time $T2_1$ of the reference dispersion and the $^1$H spin-spin relaxation time $T2_2$ of the inspection dispersion.

[5] The degradation-degree measuring device for modeling powder according to [4], wherein the modeling powder is a thermoplastic resin or a metal.

[6] The degradation-degree measuring device for modeling powder according to [4] or [5], wherein the Hansen solubility parameter of the solvent is 14 $(J/cm^3)^{1/2}$ or more and 30 $(J/cm^3)^{1/2}$ or less.

[7] A regenerated-modeling powder manufacturing method, includeing:

measuring step of using a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculating the degradation degree of the modeling powder after use based on the $^1$H spin-spin relaxation time $T2_1$ of the reference dispersion and the $^1$H spin-spin relaxation time $T2_2$ of the inspection dispersion; and

a generation step of mixing the modeling powder after use and modeling powder before use based on the degradation degree of the modeling powder after use to generate regenerated-modeling powder.

[8] A regenerated-molding powder manufacturing device, including:

measurement unit that uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculates the degradation degree of the modeling powder after use based on the $^1$H spin-spin relaxation time $T2_1$ of the reference dispersion and the $^1$H spin-spin relaxation time $T2_2$ of the inspection dispersion; and

a generation unit that mixes the modeling powder after use and modeling powder before use based on the degradation degree of the modeling powder after use to generate regenerated-modeling powder.

[9] A three-dimensional modeled object manufacturing method, including:

measuring step of using a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculating the degradation degree of the modeling powder after use based on the $^1$H spin-spin relaxation time $T2_1$ of the reference dispersion and the $^1$H spin-spin relaxation time $T2_2$ of the inspection dispersion;

a generation step of mixing the modeling powder after use and modeling powder before use based on the degradation degree of the modeling powder after use to generate regenerated-modeling powder; and

a molding step of modeling a three-dimensional modeled object by additive manufacturing using the regenerated-modeling powder.

[10] A three-dimensional modeled object manufacturing device, including:

measurement unit that uses a pulse NMR device to measure the $^1$H spin-spin relaxation time $T2_1$ of a reference

dispersion in which a reference modeling powder is dispersed in a solvent and measure the $^1$H spin-spin relaxation time $T2_2$ of an inspection dispersion in which modeling powder after use to be inspected is dispersed in the solvent and calculates the degradation degree of the modeling powder after use based on the $^1$H spin-spin relaxation time $T2_1$ of the reference dispersion and the $^1$H spin-spin relaxation time $T2_2$ of the inspection dispersion;

a generation unit that generates regenerated-modeling powder by mixing the modeling powder after use and modeling powder before use based on the degradation degree of the modeling powder after use; and

a molding unit that models a three-dimensional modeled object by additive manufacturing using the regenerated-modeling powder.

[11] A degradation-degree measuring device for modeling powder that uses a pulse NMR device to measure the $^1$H spin-spin relaxation time T2 of a dispersion in which a modeling powder is dispersed in a solvent and calculates the specific surface area of the modeling powder based on the $^1$H spin-spin relaxation time T2 of the dispersion and the $^1$H spin-spin relaxation time T2 of the solvent.

[12] A degradation-degree measuring method for modeling powder that uses a pulse NMR device to measure the $^1$H spin-spin relaxation time T2 of a dispersion in which a modeling powder is dispersed in a solvent and calculates the specific surface area of the modeling powder based on the $^1$H spin-spin relaxation time T2 of the dispersion and the $^1$H spin-spin relaxation time T2 of the solvent.

[13] The degradation-degree measuring method for modeling powder according to [12], wherein the modeling powder is a thermoplastic resin or a metal.

[14] The degradation-degree measuring method for modeling powder according to [12] or [13], wherein the Hansen solubility parameter of the solvent is 14 $(J/cm^3)^{1/2}$ or more and 30 $(J/cm^3)^{1/2}$ or less.

[15] The degradation-degree measuring method for modeling powder according to [12] or [13], wherein the $^1$H spin-spin relaxation time T2 of the solvent is 1,000 ms or more.

[16] The degradation-degree measuring method for modeling powder according to [12] or [13], wherein the degradation degree of the modeling powder after use is calculated with reference to a specific surface area of modeling powder before use that has been measured and calculated in advance.

[17] A regenerated-modeling powder manufacturing method, including:

a measurement step of sampling modeling powder after use, using a pulse NMR device to measure the $^1$H spin-spin relaxation time T2 of the dispersion in which the modeling powder after use is dispersed in a solvent and calculating the specific surface area of the modeling powder after use based on the $^1$H spin-spin relaxation time T2 of the dispersion and the $^1$H spin-spin relaxation time T2 of the solvent; and

a generation step of mixing the modeling powder after use and modeling powder before use based on the specific surface area of the modeling powder after use to generate regenerated-modeling powder.

[18] A regenerated-modeling powder manufacturing device, including:

a measurement unit that samples modeling powder after use, uses a pulse NMR device to measure the $^1$H spin-spin relaxation time T2 of the dispersion in which the modeling powder after use is dispersed in a solvent and calculates the specific surface area of the modeling powder after use based on the $^1$H spin-spin relaxation time T2 of the dispersion and the $^1$H spin-spin relaxation time T2 of the solvent; and

a generation unit that mixes the modeling powder after use and modeling powder before use based on the specific surface area of the modeling powder after use to generate regenerated-modeling powder.

[19] A three-dimensional modeled object manufacturing method, :

a measurement step of sampling modeling powder after use, using a pulse NMR device to measure the $^1$H spin-spin relaxation time T2 of the dispersion in which the modeling powder after use is dispersed in a solvent and calculating the specific surface area of the modeling powder after use based on the $^1$H spin-spin relaxation time T2 of the dispersion and the $^1$H spin-spin relaxation time T2 of the solvent;

a generation step of mixing the modeling powder after use and modeling powder before use based on the specific surface area of the modeling powder after use to generate regenerated-modeling powder; and

a molding step of modeling a three-dimensional modeled object by additive manufacturing using the regenerated-modeling powder.

[20] A three-dimensional modeled object manufacturing device, including:

a measurement unit that samples modeling powder after use, uses a pulse NMR device to measure the $^1$H spin-spin relaxation time T2 of the dispersion in which the modeling powder after use is dispersed in a solvent and calculates the specific surface area of the modeling powder after use based on the $^1$H spin-spin relaxation time T2 of the dispersion and the $^1$H spin-spin relaxation time T2 of the solvent;

a generation unit that mixes the modeling powder after use and modeling powder before use based on the specific surface area of the modeling powder after use to generate regenerated-modeling powder; and

a molding unit that models a three-dimensional modeled object by additive manufacturing using the regenerated-modeling powder.

ADVANTAGEOUS EFFECTS OF INVENTION

According to this technology, it is possible to detect the degradation degree of the modeling powder, to regenerate the modeling powder, and to suppress the degradation of the mechanical properties and dimensional accuracy of the modeled object.

BRIEF DESCRIPTION OF DRAWINGS

FIG. 1 is a functional block diagram showing an example of a regenerated-powder manufacturing device according to the present technology.

FIG. 2 is a flowchart to explain an example of the operation of a regenerated-powder manufacturing device according to the present technology.

FIG. 3 is a cross-sectional diagram showing an example of a three-dimensional modeling device according to the present technology.

FIG. 4 is a cross-sectional view illustrating the modeling operation of the three-dimensional modeling device, in which FIG. 4 (A) shows the powder supply process, FIG. 4 (B) shows the flattening process of the powder layer, FIG. 4 (C) shows the return process of the flattening roller, and FIG. 4(D) shows the modeling process of the modeled object.

FIG. 5 is a graph showing the melt flow rate of PA12 with respect to heating time.

FIG. 6 is a graph showing the relaxation time T2 of PA12 with respect to heating time.

DESCRIPTION OF EMBODIMENTS

The following describes the embodiments of the present technology in detail in the following order, with reference to the drawings.

1. DEGRADATION-DEGREE MEASURING METHOD AND MEASURING DEVICE FOR MODELING POWDER
2. REGENERATED-MODELING POWDER MANUFACTURING METHOD AND MANUFACTURING DEVICE
3. THREE-DIMENSIONAL MODELED OBJECT MANUFACTURING METHOD AND MANUFACTURING DEVICE
4. EXAMPLES

1. DEGRADATION-DEGREE MEASURING METHOD AND MEASURING DEVICE FOR MODELING POWDER

The degradation-degree measuring method and measuring device for modeling powder according to the present embodiment uses a pulse NMR device to measure the $^1$H spin-spin relaxation time T2 of a dispersion in which a modeling powder is dispersed in a solvent and calculates the specific surface area of the modeling powder based on the $^1$H spin-spin relaxation time T2 of the dispersion and the $^1$H spin-spin relaxation time T2 of the solvent. The specific surface area of the modeling powder, which appears to increase or decrease due to the heat generated by preheating in the powder bed or by the laser or electron beam irradiation, can be used as an indicator of the degradation degree of the modeling powder.

The degradation-degree measuring method and measuring device for modeling powder according to the present embodiment uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder to be inspected is dispersed in the solvent and calculates the degradation degree of the modeling powder to be inspected based on the $^1$H spin-spin relaxation time $T2_1$ of the reference dispersion and the $^1$H spin-spin relaxation time $T2_2$ of the inspection dispersion.

MODELING POWDER

The modeling powder can be any powder used in three-dimensional modeling devices without restriction, and examples may include thermoplastic resin and metal. Examples of the thermoplastic resin may include general-purpose resin and engineering plastic. Examples of the general-purpose resin may include polypropylene (PP), polyethylene (PE), polyvinyl alcohol (PVA), polyvinylidene chloride (PVDC), and polyethylene terephthalate (PET). Examples of the engineering plastic may include polyamides (PA) such as nylon 12 (PA12) and nylon 6 (PA6), polycarbonate (PC), polyetheretherketone (PEEK), fluorocarbon resins such as polytetrafluoroethylene (PTFE), liquid crystal polymer (LCP), polyamideimide (PAI), and polyetherimide (PEI). Examples of the metal may include titanium, aluminum, stainless steel, cobalt-chromium, nickel alloys, and copper alloys.

The average particle size of the powder particles is preferably 10 $\mu$m or more and 200 $\mu$m or less. The average particle size can be determined by calculating the average of the particle sizes of 200 or more particles observed under a microscope (optical microscope, metallurgical microscope, electron microscope, and the like).

SOLVENT

The solvent can be selected as appropriate for the modeling powder, e.g., based on the Hansen solubility parameter (HSP) of the solvent. The lower limit of the Hansen solubility parameter (HSP) of the solvent is preferably 5 $(J/cm^3)^{1/2}$ or more, more preferably 10 $(J/cm^3)^{1/2}$ or more, and even more preferably 14 $(J/cm^3)^{1/2}$ or more, and the upper limit of the HSP of the solvent is preferably 40 $(J/cm^3)^{1/2}$ or less, more preferably 35 $(J/cm^3)^{1/2}$ or less, and even more preferably 30 $(J/cm^3)^{1/2}$ or less. In particular, the HSP of the solvent of 14 $(J/cm^3)^{1/2}$ or more and 30 $(J/cm^3)^{1/2}$ or less will achieve excellent dispersibility of the modeling powder and allow the comparison of the degradation degrees.

The Hansen solubility parameter ($\delta$) is composed of three parameters: the dispersion term $\delta d$, the polarity term $\delta p$, and the hydrogen bonding term $\delta h$, and is expressed by the following formula (1).

$$\delta^2 = \delta d^2 + \delta p^2 + \delta h^2 \quad (1)$$

$\delta$ d: energy due to dispersion forces between molecules
$\delta$ p: energy due to dipole interactions between molecules
$\delta$ h: energy due to hydrogen bonding between molecules

The Hansen solubility parameters ($\delta$, $\delta d$, $\delta p$, $\delta h$) can be used as they are, e.g., from the values recorded in the computer software "Hansen solubility parameters in Practice 4th Edition 4.1.07 (HSPiP)".

Specific examples of the Hansen solubility parameters ($\delta$, $\delta d$, $\delta p$, $\delta h$) for solvents may include the values for ethanol ($\delta$: 26.5, $\delta d$: 15.8, $\delta p$: 8.8, $\delta h$: 19.4), DPG (dipropylene glycol, SP: 26.4, $\delta d$: 16.5, $\delta p$ : 10.6, $\delta h$: 17.7), butanol ($\delta$: 23.2, $\delta d$: 16, $\delta p$: 5.7, $\delta h$: 15.8), DMAC (dimethylacetamide, SP: 22.4, $\delta d$: 16.8, $\delta p$: 11.5, $\delta h$: 9.4), ethyl lactate ($\delta$: 21.7, $\delta d$: 16, $\delta p$: 7.6, $\delta h$: 12.5), acetic acid ($\delta$: 21.4, $\delta d$: 14.5, $\delta p$: 8, $\delta h$: 13.5), cyclohexanone (SP: 20.3, $\delta d$: 17.8, $\delta$ p: 8.4, $\delta h$: 5.1), acetone ($\delta$: 20, $\delta d$: 15.5, $\delta p$: 10.4, $\delta h$: 7), toluene ($\delta$: 18.2, $\delta d$: 18, $\delta p$: 1.4, $\delta h$: 2), MCH (methylcyclohexane, SP: 16, $\delta d$: 16, $\delta d$: 0, $\delta h$: 1), hexane ($\delta$: 14.9, $\delta d$: 14.9, $\delta p$: 0, $\delta h$: 0), and NMP (N-methyl-2-pyrrolidone, $\delta d$: 18.0, $\delta p$: 12.3, $\delta h$: 7.2), among others.

SPECIFIC SURFACE AREA OBTAINED BY USING PULSE NMR MEASUREMENT

Pulse NMR (Nuclear Magnetic Resonance) is a technique that is specialized for obtaining the $^1$H nuclear relaxation time (spin-lattice relaxation time T1) and spin-spin relaxation time T2, which are evaluation indices of molecular mobility. Hereafter, the $^1$H spin-spin relaxation time T2 is referred to as the "transverse relaxation time" or simply the "relaxation time T2" . The transverse relaxation time can be measured using a pulse NMR device such as the Acorn area manufactured by Xigo nanotools.

The pulse sequence in pulse NMR measurement can be selected as appropriate from the Hahn echo method, solid echo method, CPMG method (Carr-Purcell-Meiboom-Gill method), and 90° pulse method, among others. When the effect of diffusion of the modeling powder is expected to be large, it is preferable to apply the CPMG method. In the CPMG method, spin echoes are repeated using 180° pulses at regular intervals, and the magnetization is fixed in the xy plane of the rotating coordinate system. The total transverse magnetization decreases due to T2 relaxation during this time period, so the transverse relaxation time can be measured.

The specific surface area of the powder determined by measuring the relaxation time T2 of the powder dispersion using pulse NMR can be used as an indicator of the degradation degree of the powder. This is thought to be because the specific surface area of the powder appears to increase or decrease due to preheating in the powder bed or heat from laser or electron beam irradiation. This makes it possible to detect the degradation degree of the powder and to regenerate the powder.

The specific surface area is the surface area per unit mass of the powder, and the smaller the particles, the larger the specific surface area for the same mass. The specific surface area can be converted from the relaxation time T2 of the pulse NMR measurement using the following formula (2).

$$R_{av} = \Psi_p SL \, \rho_p (R_s - R_b) + R_b \quad (2)$$

$R_{av}$: average relaxation rate (inverse of relaxation time) of the dispersion
$\Psi_p$: particle volume ratio to solvent volume
S: surface area per unit mass (specific surface area)
L: thickness of solvent bound to particle surface
$\rho_p$: particle density
$R_s$: relaxation rate (inverse of relaxation time) of solvent bound to particle interface
$R_b$: relaxation rate (inverse of relaxation time) of solvent in free state (bulk state)

When Ka is defined by the following formula (3), the specific surface area S is expressed by the following formula (4).

$$Ka = L \, \rho_p (R_s - R_b) \quad (3)$$

$$S = (R_{av} - R_b) / Ka \, \Psi_p \quad (4)$$

Ka can be calculated using the specific surface area that is actually in contact with the solvent. For example, in the case of silica, the area in contact with the liquid can be obtained using the Sears method. Alternatively, it can be calculated using particle size measurements obtained by an estimation method such as dynamic light scattering, centrifugal sedimentation, laser diffraction, and microscopy.

In addition, $\Psi_p$ can be calculated using the following formula (5).

$$\Psi_p = (S_c / S_d) / [(1 - S_c) / T_d] \quad (5)$$

In the formula, $S_c$ is the solid content concentration (mass %) of the powder in the dispersion, $S_d$ is the density of the powder ($g/cm^3$), and $T_d$ is the density of the solvent ($g/cm^3$).

In other words, if the relaxation time T2 of the solvent (inverse of $R_b$) is known, the specific surface area S can be calculated from the relaxation time T2 of the system containing the powder particles (inverse of $R_{av}$).

In addition, the ratio between the specific surface area $S_1$ of the powder obtained by measuring the relaxation time $T2_1$ of the reference dispersion of the reference powder and the specific surface area $S_2$ of the powder obtained by measuring the relaxation time $T2_2$ of the inspection dispersion of the powder to be inspected can be calculated using the following formula (6).

$$S_2/S_1 = (R_{av2} - R_b) / (R_{av1} - R_b) \quad (6)$$

In other words, the degradation degree of the modeling powder to be inspected can be measured based on the relaxation time $T2_1$ of the reference dispersion and the relaxation time $T2_2$ of the inspection dispersion, and for example, the degradation degree can be calculated based on the ratio of the relaxation time $T2_1$ of the reference dispersion and the relaxation time $T2_2$ of the inspection dispersion. Specifically, the degradation degree may be calculated as the ratio $(T2_2/T2_1)$ of the relaxation time $T2_2$ of the inspection dispersion to the relaxation time $T2_1$ of the reference dispersion, or $(R_{av2} - R_b) / (R_{av1} - R_b)$, $R_{av2}/R_{av1}$ ( $= T2_1/T2_2$) may be calculated based on the specific surface area ratio $S_2/S_1$.

In general, the movement of liquid molecules adsorbed on the surface of particles is restricted, but liquid molecules in the bulk liquid can move freely. As a result, the transverse relaxation time of liquid molecules adsorbed on the surface of particles is shorter than the transverse relaxation time of liquid molecules in the bulk liquid.

The larger the volume fraction Ps of the dispersion medium adsorbed on the surface of particles, the shorter the transverse relaxation time. Therefore, the larger the total surface area of the particles, the shorter the transverse relaxation time. Therefore, there is a tendency that the larger the specific surface area of the particles, the shorter the transverse relaxation time, and the smaller the particle diameter, the shorter the transverse relaxation time. In addition, there is a tendency that the greater the number of particles, the shorter the transverse relaxation time.

In addition, the stronger the interaction between the particles and the dispersion medium, the shorter the transverse relaxation time. In other words, the higher the affinity between the particles and the dispersion medium, the shorter the transverse relaxation time. The affinity between the particles and the dispersion medium can be adjusted according to ,e.g., the type and number of functional groups on the surface of the particles and the compounds added to the dispersion medium.

The lower limit of the transverse relaxation time of the dispersion medium measured using a pulse NMR device is preferably 50 ms or more, more preferably 500 ms or more, and even more preferably 1,000 ms or more. The upper limit of the transverse relaxation time of the dispersion medium measured using a pulse NMR device is preferably 5,000 ms or less, more preferably 3,000 ms or less, and even more preferably 2,500 ms or less. This allows the ratio of the specific surface area of the powder to the specific surface area of the solvent to be increased.

## 2. REGENERATED-MODELING POWDER MANUFACTURING METHOD AND MANUFACTURING DEVICE

The regenerated-modeling powder manufacturing method according to the present embodiment includes: a measurement step of sampling modeling powder after use, using a pulse NMR device to measure the $^1$H spin-spin relaxation time T2 of the dispersion in which the modeling powder after use is dispersed in a solvent and calculating the specific surface area of the modeling powder after use based on the $^1$H spin-spin relaxation time T2 of the dispersion and the $^1$H spin-spin relaxation time T2 of the solvent; and a generation step of mixing the modeling powder after use and modeling powder before use based on the specific surface area of the modeling powder after use to generate regenerated-modeling powder.

In addition, the regenerated-modeling powder manufacturing method according to the present embodiment includes: measuring step of using a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculating the degradation degree of the modeling powder after use based on the $^1$H spin-spin relaxation time $T2_1$ of the reference dispersion and the $^1$H spin-spin relaxation time $T2_2$ of the inspection dispersion; and a generation step of mixing the modeling powder after use and modeling powder before use based on the degradation degree of the modeling powder after use to generate regenerated-modeling powder.

The regenerated-modeling powder manufacturing device according to the present embodiment includes: a measurement unit that samples modeling powder after use, uses a pulse NMR device to measure the $^1$H spin-spin relaxation time T2 of the dispersion in which the modeling powder after use is dispersed in a solvent and calculates the specific surface area of the modeling powder after use based on the $^1$H spin-spin relaxation time T2 of the dispersion and the $^1$H spin-spin relaxation time T2 of the solvent; and a generation unit that mixes the modeling powder after use and modeling powder before use based on the specific surface area of the modeling powder after use to generate regenerated-modeling powder.

In addition, the regenerated-modeling powder manufacturing device according to the present embodiment includes: measurement unit that uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculates the degradation degree of the modeling powder after use based on the $^1$H spin-spin relaxation time $T2_1$ of the reference dispersion and the $^1$H spin-spin relaxation time $T2_2$ of the inspection dispersion; and a generation unit that generates regenerated-modeling powder by mixing the modeling powder after use and modeling powder before use based on the degradation degree of the modeling powder after use.

According to the present embodiment, e.g., by calculating the degradation degree of the modeling powder after use with reference to the specific surface area of the modeling powder before use that has been measured and calculated in advance, or by calculating the degradation degree of the modeling powder after use based on the relaxation time $T2_1$ of the reference powder and the relaxation time $T2_2$ of the powder after use to be inspected, the mixing ratio of the modeling powder after use and modeling powder before use can be calculated, and the degradation degree of molding powder after mixing can be calculated. This makes it possible to manufacture regenerated-modeling powder with a desired degradation degree (specific surface area).

## REGENERATED-POWDER MANUFACTURING DEVICE

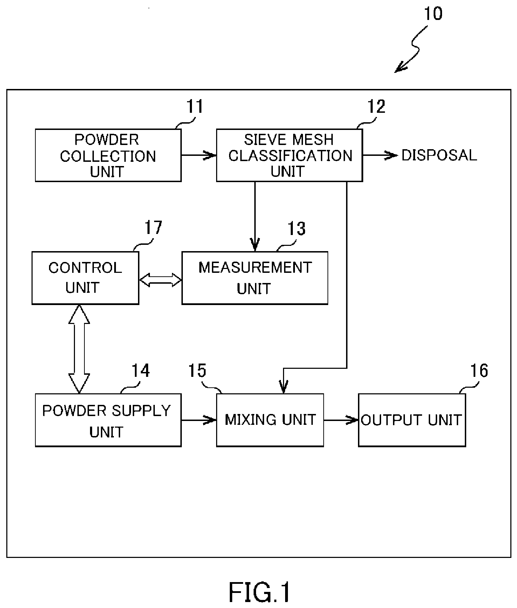

FIG. 1 is a functional block diagram showing an example of a regenerated-powder manufacturing device according to the present technology. As shown in FIG. 1, the regenerated-powder manufacturing device 10 includes a powder collection unit 11 that collects powder after use, a sieve mesh classification unit 12 that sieves powder, a measurement unit 13 that measures the degradation degree of the powder, a powder supply unit 14 that supplies powder, a mixing unit 15 that mixes the powder that has passed through the sieve mesh with new powder, an output unit 16 that outputs the regenerated powder, and a control unit 17 that controls the amount of new powder supplied from the powder supply unit 14 to the mixing unit 15. When using powder that has not been affected by the heat of preheating in the powder bed or by lasers or electron beams as the powder after use, the sieve mesh classification unit 12 may be omitted.

The powder collection unit 11 collects the powder after use, e.g., in the three-dimensional modeling device 20 described below. For example, the powder 41 remaining in a modeling tank 40 without contributing to the formation of a modeled object in the three-dimensional modeling device 20 described below may be collected, or the powder 51 in the collection tank 50 may be collected. Powder conveyance methods for powder collection may include a screw conveyor system using a screw and an air transport system using air.

The sieve mesh classification unit 12 classifies the powder after use collected in the powder collection unit 11 using a sieve mesh. This separates the powder after use into fine powder, which is composed of fine particles that pass through the sieve mesh, and coarse powder, which is composed of coarse particles that remain on the sieve mesh. The coarse powder may be disposed of, or it may be crushed in a ball mill or similar device and the fine particles extracted by air flow classification may be collected in the powder collection unit 11.

The measurement unit 13 samples a portion of the powder that has passed through the sieve mesh and measures the degradation degree of the powder. Specifically, the $^1$H spin-spin relaxation time T2 of the dispersion of the powder in the solvent is measured using a pulse NMR device to calculate the specific surface area of the powder. The specific surface area calculation results are transmitted to the control unit 17. In addition, the measurement unit 13 may sample the mixed powder in the mixing unit 15, calculate the specific surface area of the mixed powder using a pulse NMR device, and transmit the calculation results to the control unit 17.

The powder supply unit 14 stores new powder, and supplies the predetermined amount of new powder instructed by the control unit 17 to the mixing unit 15. The mixing unit 15 mixes the powder that has passed through the sieve mesh of the sieve mesh classification unit 12 with the new powder supplied from the powder supply unit 14. The output unit 16 outputs the powder mixed in the mixing unit 15 as usable regenerated powder. For example, the output unit 16 outputs the regenerated powder to the powder tank 30 of the three-dimensional modeling device 20 described below.

The control unit 17 controls the processing of each unit. Specifically, the control unit 17 controls the amount of new powder supplied from the powder supply unit 14 to the mixing unit 15 based on the specific surface area calculated by the measurement unit 13. For example, the control unit 17 may determine a first supply amount of new powder based on the specific surface area of powder that has passed through the sieve mesh, and determine a second supply amount of new powder based on the specific surface area of powder after mixing. The control unit 17 may also control the amount of powder after use supplied to the sieve mesh classification unit 12.

OPERATION OF REGENERATED-POWDER MANUFACTURING DEVICE

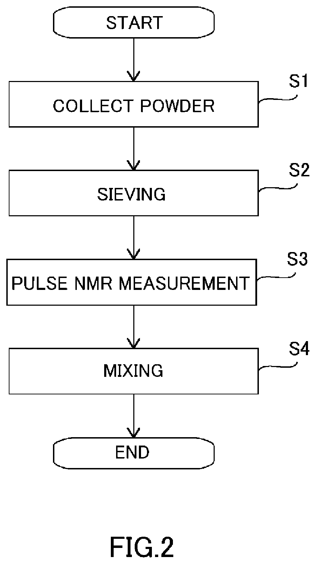

Next, referring to FIGS. 1 and 2, the operation of the regenerated-powder manufacturing device will be explained. FIG. 2 is a flowchart to explain an example of the operation of a regenerated-powder manufacturing device according to the present technology.

As shown in FIG. 2, first, in step S1, the powder collection unit 11 collects, e.g., the powder 41 remaining in the modeling tank 40 without contributing to the formation of a modeled object in the three-dimensional modeling device 20 described below, the powder 51 in the collection tank 50, and the like.

In step S2, the sieve mesh classification unit 12 classifies the powder after use collected in the powder collection unit 11 using a sieve mesh. This separates the powder after use into fine powder, which is composed of fine particles that pass through the sieve mesh, and coarse powder, which is composed of coarse particles that remain on the sieve mesh. The coarse powder may be disposed of, or it may be crushed in a ball mill or similar device and the fine particles extracted by air flow classification may be collected in the powder collection unit 11.

In step S3, the measurement unit 13 samples a portion of the fine powder that passed through the sieve mesh in step S2, and uses a pulse NMR device to measure the $^1$H spin-spin relaxation time T2 of the dispersion of the powder after use in the solvent and calculates the specific surface area of the powder after use. The control unit 17 calculates the first supply amount of new powder to be supplied from the powder supply unit 14 to the mixing unit 15 based on the specific surface area of the powder after use.

In step S4, the powder supply unit 14 supplies the first supply amount of new powder calculated by the control unit 17 to the mixing unit 15, and the mixing unit 15 mixes the powder that has passed through the sieve mesh of the sieve mesh classification unit 12 with the new powder supplied from the powder supply unit 14. In addition, the measurement unit 13 may sample a portion of the mixed powder from the mixing unit 15, calculate the specific surface area of the mixed powder using a pulse NMR device, and the control unit 17 may calculate a second supply amount of new powder based on the specific surface area of the mixed powder to cause the powder supply unit 14 to supply new powder to the mixing unit 15. The output unit 16 outputs the powder mixed in the mixing unit 15 as usable regenerated powder, e.g., to the powder tank 30 of the three-dimensional modeling device 20 described below.

As described above, by mixing powder after use and new powder based on the specific surface area of powder after use calculated using the pulse NMR device, it is possible to manufacture regenerated powder with a specific surface area of a predetermined value.

In the aforementioned regenerated-modeling powder manufacturing device, the specific surface area of the powder is calculated by the measurement unit 13, and the supply amount of new powder is controlled by the control unit 17 based on the specific surface area, but the operation is not limited to this. For example, after calculating the degradation degree of the modeling powder after use based on the relaxation time $T2_1$ of the reference powder and the relaxation time $T2_2$ of the powder after use, the control unit 17 may control the supply amount of new powder based on the degradation degree of the modeling powder after use.

## 3. THREE-DIMENSIONAL MODELED OBJECT MANUFACTURING METHOD AND MANUFACTURING DEVICE

The three-dimensional modeled object manufacturing method according to the present embodiment includes: a measurement step of sampling modeling powder after use, using a pulse NMR device to measure the $^1$H spin-spin relaxation time T2 of the dispersion in which the modeling powder after use is dispersed in a solvent and calculating the specific surface area of the modeling powder after use based on the $^1$H spin-spin relaxation time T2 of the dispersion and the $^1$H spin-spin relaxation time T2 of the solvent; a generation step of mixing the modeling powder after use and modeling powder before use based on the specific surface area of the modeling powder after use to generate regenerated-modeling powder; and a molding step of modeling a three-dimensional modeled object by additive manufacturing using the regenerated-modeling powder.

In addition, the three-dimensional modeled object manufacturing method according to the present embodiment includes: measuring step of using a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculating the degradation degree of the modeling powder after use based on the $^1$H spin-spin relaxation time $T2_1$ of the reference dispersion and the $^1$H spin-spin relaxation time $T2_2$ of the inspection dispersion; a generation step of mixing the modeling powder after use and modeling powder before use based on the degradation degree of the modeling powder after use to generate regenerated-modeling powder; and a molding step of modeling a three-dimensional modeled object by additive manufacturing using the regenerated-modeling powder.

The three-dimensional modeled object manufacturing device according to the present embodiment includes: a measurement unit that samples modeling powder after use, uses a pulse NMR device to measure the $^1$H spin-spin relaxation time T2 of the dispersion in which the modeling powder after use is dispersed in a solvent and calculates the specific surface area of the modeling powder after use based on the $^1$H spin-spin relaxation time T2 of the dispersion and the $^1$H spin-spin relaxation time T2 of the solvent; a generation unit that mixes the modeling powder after use and modeling powder before use based on the specific surface area of the modeling powder after use to generate regenerated-modeling powder; and a molding unit that models a three-dimensional modeled object by additive manufacturing using the regenerated-modeling powder.

In addition, the three-dimensional modeled object manufacturing device according to the present embodiment includes: measurement unit that uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculates the degradation degree of the modeling powder after use based on the $^1$H spin-spin relaxation time $T2_1$ of the reference dispersion and the $^1$H spin-spin relaxation time $T2_2$ of the inspection dispersion; a generation unit that generates regenerated-modeling powder by mixing the modeling powder after use and modeling powder before use based on the degradation degree of the modeling powder after use; and a molding unit that models a three-dimensional modeled object by additive manufacturing using the regenerated-modeling powder.

According to the present embodiment, since a three-dimensional modeled object is formed by additive manufacturing using regenerated modeling powder with a predetermined degradation degree (specific surface area), it is possible to suppress the degradation of the mechanical properties and dimensional accuracy of the modeled object due to degradation of the powder.

The examples of the additive manufacturing method used in the three-dimensional modeling device may include selective laser sintering (SLS), selective laser melting (SLM), and electron beam melting (EBM). Generally, SLS is used when the powder used for modeling is resin, and SLS, SLM and EBM are used when the modeling powder is metal.

The following explains a three-dimensional modeling device that uses the powder bed method, in which a thin layer of modeling powder is spread over a receptacle called a powder bed, and a laser or electron beam is scanned over the powder to form the shape of the cross-section of the modeled object.

THREE-DIMENSIONAL MODELING DEVICE

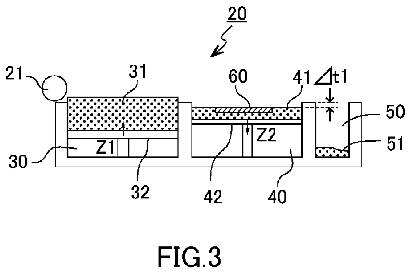

FIG. 3 is a cross-sectional diagram showing an example of a three-dimensional modeling device according to the present technology.

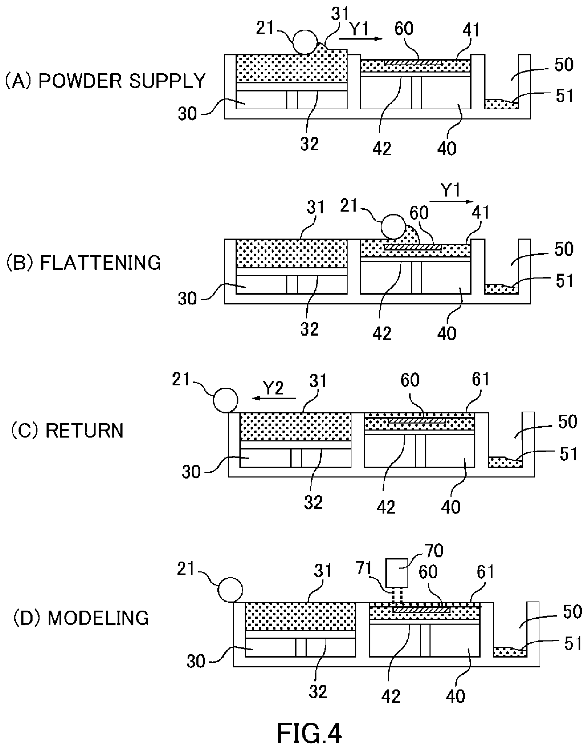

FIG. 4 is a cross-sectional view illustrating the modeling operation of the three-dimensional modeling device, in which FIG. 4 (A) shows the powder supply process, FIG. 4 (B) shows the flattening process of the powder layer, FIG. 4 (C) shows the return process of the flattening roller, and FIG. 4 (D) shows the modeling process of the modeled object.

The three-dimensional modeling device 20 includes a powder tank 30 for supplying powder, a modeling tank 40 for modeling a modeled object, and a collection tank 50 for collecting powder. The three-dimensional modeling device 20 also includes a modeling unit 70 that emits laser light 71 to form a modeling layer 60 in the powder layer 61 and forms a 3D modeled object by stacking the modeling layers 60. In addition, the three-dimensional modeling device 20 may include the aforementioned regenerated-powder manufacturing device 10, which may supply the regenerated powder output from the output unit 16 to the powder tank 30, the powder 41 remaining in the modeling tank 40 without contributing to the formation of a modeled object to the powder collection unit 11, and the powder 51 in the collection tank 50 to the powder collection unit 11. Powder conveyance methods for powder supply may include a screw conveyor system using a screw and an air transport system using air.

The flattening roller 21 is a flattening means (recoater), which moves back and forth relative to the top surface of the modeling tank 40, transfers and supplies the powder 31 from the powder tank 30 to the modeling tank 40, flattens the powder 41 in the modeling tank 40 to form a powder layer 61, and collects the powder 51 in the collection tank 50. It should be noted that, a flattening means such as a plate-shaped member (blade) may be used instead of the flattening roller 21.

The powder tank 30 is box-shaped with an open top that holds the powder 31 to be supplied to the modeling tank 40, and is provided with a supply stage 32 at the bottom. The supply stage 32 moves up and down in the vertical direction (height direction), and by moving it up in the direction of the arrow Z1, the powder 31 on the top surface is transferred and supplied by the flattening roller 21. Here, the powder 31 may be the regenerated powder output from the output unit 16 of the aforementioned regenerated-powder manufacturing device 10.

The modeling tank 40 is box-shaped with an open top that holds the powder 41 used to form the modeled object, and has a modeling stage 42 at the bottom. The modeling stage 42 moves up and down in the vertical direction (height direction), and by moving it down by $\Delta t1$ in the direction of the arrow Z2, a powder layer 61 is formed on the top surface. In addition, the modeling tank 40 forms a modeling layer 60 in the powder layer 61 by laser light 71 emitted from the modeling unit 70, and a three-dimensional modeled object is formed by stacking the modeling layers 60. The powder 41 remaining in the modeling tank 40 without contributing to the formation of a modeled object may be collected in the powder collection unit 11 of the aforementioned regenerated-powder manufacturing device 10 as the powder after use.

The collection tank 50 stores the remaining powder 51 that has not been used to form the powder layer 61 among the powder 31 that is transferred and supplied by the flattening roller 21 when forming the powder layer 61 on the top surface of the modeling tank 40. The powder 51 in the collection tank 50 may be collected in the powder collection unit 11 of the aforementioned regenerated-powder manufacturing device 10 as the powder after use.

The modeling unit 70 emits laser light 71 onto the powder layer 61 on the modeling stage 42, and the entire modeling unit 70 moves back and forth in the Y direction, which is perpendicular to the X direction.

MODELING OPERATION

Next, referring to FIGS. 3 and 4, the modeling operation of the three-dimensional modeling device will be explained. Here, the explanation is stated from the state where the first modeling layer 60 is formed on the modeling stage 42 of the modeling tank 40, as shown in FIGS. 3 and 4 (A).

As shown in FIGS. 3 and 4 (A), when forming the second powder layer 60, the supply stage 32 of the supply tank 30 is raised in the Z1 direction, and the modeling stage 42 of the modeling tank 40 is descended in the Z2 direction. At this time, the descent distance of the modeling stage 42 is set such that the gap between the surface of the first powder layer and the lower part (lower tangent part) of the flattening roller 21 becomes $\Delta t1$. This gap $\Delta t1$ corresponds to the thickness (layer pitch) of the second powder layer 61. The gap $\Delta t1$ is preferably between 1 and 100 $\mu$m.

Next, as shown in FIG. 4 (B), the powder 31 located on the top surface of the supply tank 30 is transferred to the modeling tank 40 by moving the flattening roller 21 in the Y1 direction (towards the modeling tank 40) while rotating it (powder supply process).

Furthermore, as shown in FIG. 4 (B), the flattening roller 21 is moved parallel to the stage surface of the modeling stage 42 of the modeling tank 40, and the powder 41 is flattened while being supplied to the modeling tank 40 (flattening process). As a result, as shown in FIG. 4 (C), the powder layer 61 with a predetermined thickness $\Delta t1$ is formed on the modeling stage 42 of the modeling tank 40. At this time, the remaining powder 51 that was not used to form the powder layer 61 falls into the collection tank 50.

After the powder layer 61 has been formed, the flattening roller 21 is moved in the Y2 direction as shown in FIG.

4(C) and returned to its initial position (home position) (return process).

After that, as shown in FIG. 4 (D), laser light 71 is emitted from the modeling unit 70 to form the modeling layer 60 in the powder layer 61 (modeling process). The 3D model layer 60 is formed, e.g., by the powder layer 61 heating up due to the laser light 71, and the powder sintering or melting.

After that, by repeating the powder supply process, flattening process, return process, and modeling process described above the required number of times, it is possible to manufacture a 3D modeled object formed by stacking the modeling layers 60. Here, after the 3D modeled object is completed, the powder 41 remaining in the modeling tank 40 and the powder 51 collected in the collection tank 50 is supplied to the powder collection unit 11 of the regenerated-powder manufacturing device 10, and the regenerated powder output from the output unit 16 is supplied to the supply tank 30, thereby suppressing the degradation of the mechanical properties and dimensional accuracy of the modeled object due to powder degradation.

EXAMPLES

4. EXAMPLES

In the present examples, the modeling powder was dispersed in various solvents, and the specific surface area of the modeling powder was calculated using a pulse NMR device.

The following were prepared as the modeling powder.

PA12 (nylon 12 (polyamide), average particle diameter 60 $\mu$m)

· New powder (modeling powder before use, which has not been used in a three-dimensional modeling device)
· Used powder (modeling powder after use, which has been used in a three-dimensional modeling device)
· Regenerated powder (mixture of new powder and used powder, new : used = 20 : 80 (mass ratio))

PP (polypropylene, average particle size 51$\mu$m)

· New powder (modeling powder before use, which has not been used in a three-dimensional modeling device)
· Used powder (modeling powder after use, which has been used in a three-dimensional modeling device)
· Regenerated powder (mixture of new powder and used powder, new : used = 20 : 80 (mass ratio))

Titanium (average particle diameter 10 to 85$\mu$m)

· New powder (modeling powder before use, which has not been used in a three-dimensional modeling device)
· Used powder (modeling powder after use, which has been used in a three-dimensional modeling device)

The following solvents were prepared.

Ethanol ($\delta$: 26.5, $\delta$d: 15.8, $\delta$p: 8.8, $\delta$h: 19.4)
DPG (dipropylene glycol, SP: 26.4, $\delta$d: 16.5, $\delta$p: 10.6, $\delta$h: 17.7)
Butanol ($\delta$: 23.2, $\delta$d: 16, $\delta$p: 5.7, $\delta$h: 15.8)
DMAC (dimethylacetamide, SP: 22.4, $\delta$d: 16.8, $\delta$p: 11.5, $\delta$h: 9.4)
Ethyl lactate ($\delta$: 21.7, $\delta$d: 16, $\delta$p: 7.6, $\delta$h: 12.5)
Acetic acid ($\delta$: 21.4, $\delta$d: 14.5, $\delta$p: 8, $\delta$h: 13.5)
Cyclohexanone (SP: 20.3, $\delta$d: 17.8, $\delta$p: 8.4, $\delta$h: 5.1)
Acetone ($\delta$: 20, $\delta$d: 15.5, $\delta$p: 10.4, $\delta$h: 7)
Toluene ($\delta$: 18.2, $\delta$d: 18, $\delta$p: 1.4, $\delta$h: 2)
MCH (methylcyclohexane, SP: 16, $\delta$d: 16, $\delta$d: 0, $\delta$h: 1)
Hexane ($\delta$: 14.9, $\delta$d: 14.9, $\delta$p: 0, $\delta$h: 0)

PULSE NMR MEASUREMENT

Using a pulse NMR device (Acorn area manufactured by Xigo nanotools), the $^{1}$H spin-spin relaxation time T2 in the dispersion of the modeling powder dispersed in the solvent was measured, and the specific surface area of the modeling powder was calculated based on the $^{1}$H spin-spin relaxation time T2 in the dispersion and the $^{1}$H spin-spin relaxation time T2 in the solvent. The specific surface area was calculated using the following formula (4) described above.

$$S = (R_{av} - R_{b}) / Ka\,\Psi_{p} \ (4)$$

$R_{av}$: average relaxation rate of the dispersion (inverse of the relaxation time T2 of the dispersion)
$\Psi_{p}$: particle volume ratio to solvent volume
S: surface area per unit mass (specific surface area)
Rb: relaxation rate of solvent in free (bulk) state (inverse of the relaxation time T2 of the solvent)
In this example, the specific surface area is evaluated as a relative value between new and used powders, so the Ka value in the specific surface area calculation is set to a constant value of 0.000312, and the $\Psi_{p}$ value is set to a constant value of 1 (solvent volume = particle volume).

Measurements using a pulse NMR device were carried out under the following conditions.

Pulse sequence: CPMG method
Resonance frequency: 13 MHz
Bulk Relaxation Time: 2,600.0 ms
Specific Surface Relaxivity: 0.000264 g/m$^{2}$/ms
Measurement temperature: 25°C
Amount of measurement sample: 1.0 cm$^{3}$
Time from mixing to measurement: 3 min

In this example, the specific surface area of the solvent was calculated using the following formula (4-1), and the specific surface area of the dispersion was calculated using the following formula (4-2).

$$S.A. \ (solvent) = (1 / T2 \ (solvent) - 1 / 2600) / 0.000312 \ (4\text{-}1)$$

$$S.A. \ (dispersion) = (1 / T2 \ (dispersion) - 1 / T2 \ (solvent)) / 0.000312 \ (4\text{-}2)$$

S.A.: specific surface area
T2: $^{1}$H spin-spin relaxation time T2 [ms]

Measurement Example 1

A dispersion was prepared using PA12 (new powder, used powder, and regenerated powder) as the modeling powder and ethanol as the solvent. Then, each relaxation time T2 of the solvent and the dispersion was measured using the pulse NMR device, and the specific surface area was calculated.

Measurement Example 2

A dispersion was prepared using PA12 (new powder, used powder, and regenerated powder) as the modeling powder and DPG (dipropylene glycol) as the solvent. Then, each relaxation time T2 of the solvent and the dispersion was measured using the pulse NMR device, and the specific surface area was calculated.

Measurement Example 3

A dispersion was prepared using PA12 (new powder, used powder, and regenerated powder) as the modeling powder and butanol as the solvent. Then, each relaxation time T2 of the solvent and the dispersion was measured using the pulse NMR device, and the specific surface area was calculated.

Measurement Example 4

A dispersion was prepared using PA12 (new powder, used powder, and regenerated powder) as the modeling powder and DMAC (dimethylacetamide) as the solvent. Then, each relaxation time T2 of the solvent and the dispersion was measured using the pulse NMR device, and the specific surface area was calculated.

Measurement Example 5

A dispersion was prepared using PA12 (new powder and used powder) as the modeling powder and acetic acid as the solvent. Then, each relaxation time T2 of the solvent and the dispersion was measured using the pulse NMR device, and the specific surface area was calculated.

Measurement Example 6

A dispersion was prepared using PA12 (new powder, used powder, and regenerated powder) as the modeling powder and cyclohexane as the solvent. Then, each relaxation time T2 of the solvent and the dispersion was measured using the pulse NMR device, and the specific surface area was calculated.

Measurement Example 7

A dispersion was prepared using PA12 (new powder and used powder) as the modeling powder and acetone as the solvent. Then, each relaxation time T2 of the solvent and the dispersion was measured using the pulse NMR device, and the specific surface area was calculated.

Measurement Example 8

A dispersion was prepared using PA12 (new powder and used powder) as the modeling powder and toluene as the solvent. Then, each relaxation time T2 of the solvent and the dispersion was measured using the pulse NMR device, and the specific surface area was calculated.

Measurement Example 9

A dispersion was prepared using PA12 (new powder, used powder, and regenerated powder) as the modeling powder and MCH (methylcyclohexane) as the solvent. Then, each relaxation time T2 of the solvent and the dispersion was measured using the pulse NMR device, and the specific surface area was calculated.

Measurement Example 10

A dispersion was prepared using PA12 (new powder and used powder) as the modeling powder and hexane as the solvent. Then, each relaxation time T2 of the solvent and the dispersion was measured using the pulse NMR device, and the specific surface area was calculated.

Measurement Example 11

A dispersion was prepared using PP (new powder, used powder, and regenerated powder) as the modeling powder and DPG (dipropylene glycol) as the solvent. Then, each relaxation time T2 of the solvent and the dispersion was measured using the pulse NMR device, and the specific surface area was calculated.

Measurement Example 12

A dispersion was prepared using PP (new powder, used powder, and regenerated powder) as the modeling powder and DMAC (dimethylacetamide) as the solvent. Then, each relaxation time T2 of the solvent and the dispersion was measured using the pulse NMR device, and the specific surface area was calculated.

Measurement Example 13

A dispersion was prepared using PP (new powder, used powder, and regenerated powder) as the modeling powder and ethyl lactate as the solvent. Then, each relaxation time T2 of the solvent and the dispersion was measured using the pulse NMR device, and the specific surface area was calculated.

Measurement Example 14

A dispersion was prepared using PP (new powder, used powder, and regenerated powder) as the modeling powder and cyclohexanone as the solvent. Then, each relaxation time T2 of the solvent and the dispersion was measured using the pulse NMR device, and the specific surface area was calculated.

Measurement Example 15

A dispersion was prepared using PP (new powder, used powder, and regenerated powder) as the modeling powder and MCH (methylcyclohexane) as the solvent. Then, each relaxation time T2 of the solvent and the dispersion was measured using the pulse NMR device, and the specific surface area was calculated.

Measurement Example 16

A dispersion was prepared using PP (new powder, used powder, and regenerated powder) as the modeling powder and hexane as the solvent. Then, each relaxation time T2 of the solvent and the dispersion was measured using the pulse NMR device, and the specific surface area was calculated.

Measurement Example 17

A dispersion was prepared using titanium (new powder and used powder) as the modeling powder and DPG (dipropylene glycol) as the solvent. Then, each relaxation time T2 of the solvent and the dispersion was measured using the pulse NMR device, and the specific surface area was calculated. The used titanium was measured after being sieved ten times.

Table 1 shows the results of pulse NMR measurements for Measurement Examples 1 to 17. In Table 1, T2 is the $^1$H spin-spin relaxation time T2, S.A. is the specific surface area, solvent ratio is the ratio of the solvent to S.A., and new powder ratio is the ratio of the new powder to S.A.

[Table 1]

| measurement No. | powder | solvent | | powder : solvent [mass ratio] | solvent | | new powder dispersion | | | use powder dispersion | | | | regenerated powder dispersion | | | |
|---|---|---|---|---|---|---|---|---|---|---|---|---|---|---|---|---|---|
| | | | SP | | T2 | S.A. | T2 | S.A. | solvent ratio | T2 | S.A. | solvent ration | new powder ratio | T2 | S.A. | solvent ration | new powder ratio |
| 1 | PA12 | ethanol | 26.5 | 1: 1.5 | 1829.9 | 0.52 | 189.3 | 15.18 | 29.2 | 709.1 | 2.77 | 5.3 | 0.18 | 591.9 | 3.66 | 8.0 | 0.24 |
| 2 | | DPG | 26.4 | 1: 1.5 | 84.5 | 36.70 | 69.4 | 8.25 | 0.2 | 73.9 | 5.44 | 0.1 | 0.66 | 71.8 | 6.71 | 1.2 | 0.81 |
| 3 | | butanol | 23.2 | 1:1.5 | 1035.9 | 1.86 | 331.5 | 6.57 | 3.5 | 296.2 | 7.73 | 4.2 | 1.18 | 505.1 | 3.25 | 2.7 | 0.49 |
| 4 | | DMAC | 22.4 | 1: 1.5 | 2386.0 | 0.11 | 343.2 | 8.00 | 72.7 | 858.6 | 2.39 | 21.7 | 0.30 | 768.8 | 2.83 | 24.9 | 0.35 |
| 5 | | acetic acid | 21.4 | 1:1.5 | 1613.2 | 0.75 | 346.0 | 7.28 | 9.7 | 593.7 | 3.41 | 4.5 | 0.47 | - | | | |
| 6 | | cyclohexanone | 20.3 | 1: 1.5 | 1878.3 | 0.47 | 737.1 | 2.64 | 5.6 | 1174.0 | 1.02 | 2.2 | 0.39 | 1036.8 | 1.38 | 3.9 | 0.52 |
| 7 | | acetone | 20 | 1: 1.5 | 3320.9 | -0.27 | 759.0 | 3.26 | -12.1 | 1167.7 | 1.78 | -6.6 | 0.55 | - | | | |
| 8 | | toluene | 18.2 | 1: 1.5 | 2769.7 | -0.08 | 728.6 | 3.24 | -40.5 | 1124.1 | 1.69 | -21.1 | 0.52 | - | | | |
| 9 | | MCH | 16 | 1: 1.5 | 1741.1 | 0.61 | 1127.4 | 1.00 | 1.6 | 1390.5 | 0.46 | 0.8 | 0.46 | 1232.8 | 0.76 | 2.3 | 0.76 |
| 10 | | hexane | 14.9 | 1: 1.5 | 2175.3 | 0.24 | 1134.7 | 1.35 | 5.6 | 1654.0 | 0.46 | 1.9 | 0.34 | - | | | |
| 11 | PP | DPG | 26.4 | 1: 1.5 | 84.8 | 36.56 | 82.7 | 0.96 | 0.0 | 80.3 | 2.12 | 0.1 | 2.21 | 81.8 | 1.39 | 1.0 | 1.45 |
| 12 | | DMAC | 22.4 | 1: 1.5 | 2531.5 | 0.03 | 2033.5 | 0.31 | 10.3 | 1924.7 | 0.40 | 13.3 | 1.29 | 1948.8 | 0.38 | 12.0 | 1.23 |
| 13 | | ethyl lactate | 21.7 | 1: 1.5 | 1694.8 | 0.66 | 1231.4 | 0.71 | 1.1 | 1161.4 | 0.87 | 1.3 | 1.23 | 1184.5 | 0.81 | 2.2 | 1.14 |
| 14 | | cyclohexanone | 20.3 | 1: 1.5 | 2416.3 | 0.09 | 1431.3 | 0.91 | 10.1 | 1250.2 | 1.24 | 13.8 | 1.36 | 1273.4 | 1.19 | 15.2 | 1.31 |
| 15 | | MCH | 16 | 1: 1.5 | 1714.1 | 0.64 | 576.6 | 3.69 | 5.8 | 465.7 | 5.01 | 7.8 | 1.36 | 473.8 | 4.89 | 8.8 | 1.33 |
| 16 | | hexane | 14.9 | 1: 1.5 | 2427.9 | 0.09 | 807.8 | 2.62 | 29.1 | 737.6 | 3.03 | 33.7 | 1.16 | 802.9 | 2.67 | 32.6 | 1.02 |
| 17 | titanium | DPG | 26.4 | 1: 0.2 | 87.7 | 35.31 | 64.7 | 12.99 | 0.4 | 68.2 | 10.45 | 0.3 | 0.80 | - | | | |

As shown in Table 1, it was found that the specific surface area of the modeling powder (new powder, used powder, and regenerated powder) can be calculated using a pulse NMR device, and that this can be used as an indicator of the degradation degree of the modeling powder. It was found that various solvents with Hansen solubility parameters of 14 $(J/cm^3)^{1/2}$ or more and 30 $(J/cm^3)^{1/2}$ or less can be used. In addition, it was found that it is possible to increase the ratio of the specific surface area of the powder to the specific surface area of the solvent by ensuring that the solvent relaxation time T2 is 1,000 ms or more.

In addition, it was found that the specific surface area of PA12 and titanium decreases due to powder degradation, while the specific surface area of PP increases due to powder degradation. It was also found that it is preferable to calculate the degradation degree of the modeling powder after use (used powder) and the regenerated powder by using the specific surface area of the modeling powder before use (new powder) as a reference (e.g. 100%).

The following modeling powder was dispersed in a solvent, and each relaxation time T2 [ms] of the modeling powder was measured using the pulse NMR device, and the ratio ($T2_1/T2_2$, $T2_2/T2_1$) of the relaxation time $T2_1$ of the reference modeling powder and the relaxation time $T2_2$ of the modeling powder to be inspected was calculated.

The following were prepared as modeling powders.

PA12 (nylon 12 (polyamide), average particle diameter 60 $\mu$m)

· New powder (modeling powder before use, which has not been used in a three-dimensional modeling device)
· Used powder (modeling powder after use, which has been used in a three-dimensional modeling device)

PA11 (nylon 11 (polyamide), average particle diameter 60 $\mu$m)

· New powder (modeling powder before use, which has not been used in a three-dimensional modeling device)
· Used powder (modeling powder after use, which has been used in a three-dimensional modeling device)

PA6 (nylon 6 (polyamide), average particle size 50$\mu$m)

· Regenerated powder (mixture of new powder and used powder, new : used = 20 : 80 (mass ratio))
· Used powder (modeling powder after use, which has been used in a three-dimensional modeling device)

PPS (polyphenylene sulfide, average particle size 50$\mu$m)

· New powder (modeling powder before use, which has not been used in a three-dimensional modeling device)
· Used powder (modeling powder after use, which has been used in a three-dimensional modeling device)

Titanium (average particle diameter 10 to 85$\mu$m)

· New powder (modeling powder before use, which has not been used in a three-dimensional modeling device)
· Used powder (modeling powder after use, which has been used in a three-dimensional modeling device)

The following solvents were prepared.
NMP (N-methyl-2-pyrrolidone, $\delta$d: 18.0, $\delta$p: 12.3, $\delta$h: 7.2)

Measurement Example 18

Using PA12 (new powder and used powder) as the modeling powder and NMP (N-methyl-2-pyrrolidone) as the solvent, dispersion A (for new powder) and dispersion B (for used powder) were prepared. Then, each relaxation time T2 of dispersion A (for new powder) and dispersion B (for used powder) was measured using the pulse NMR device, and the ratio was calculated.

Measurement Example 19

Using PA11 (new powder and used powder) as the modeling powder and NMP (N-methyl-2-pyrrolidone) as the solvent, dispersion A (for new powder) and dispersion B (for used powder) were prepared. Then, each relaxation time T2 of dispersion A (for new powder) and dispersion B (for used powder) was measured using the pulse NMR device, and the ratio was calculated.

Measurement Example 20

Using PA6 (regenerated powder and used powder) as the modeling powder and NMP (N-methyl-2-pyrrolidone) as the solvent, dispersion A (for regenerated powder) and dispersion B (for used powder) were prepared. Then, each relaxation time T2 of dispersion A (for regenerated powder) and dispersion B (for used powder) was measured using the pulse NMR device, and the ratio was calculated.

Measurement Example 21

Using PPS (new powder and used powder) as the modeling powder and NMP (N-methyl-2-pyrrolidone) as the solvent, dispersion A (for new powder) and dispersion B (for used powder) were prepared. Then, each relaxation time T2 of dispersion A (for new powder) and dispersion B (for used powder) was measured using the pulse NMR device, and the ratio was calculated.

Measurement Example 22

Using titanium (new powder and used powder) as the modeling powder and NMP (N-methyl-2-pyrrolidone) as the solvent, dispersion A (for new powder) and dispersion B (for used powder) were prepared. Each relaxation time T2 of the solvent and the dispersion was then measured using a pulse NMR device. The used titanium was measured after being sieved ten times.

Measurement Example 23

Using PA12 (new powder and used powder) as the modeling powder and a mixed solvent of NMP (N-methyl-2-pyrrolidone) : ethyl lactate (9:1) as the solvent, dispersion A (for new powder) and dispersion B (for used powder) were prepared. Then, each relaxation time T2 of dispersion A (for new powder) and dispersion B (for used powder) was measured using the pulse NMR device, and the ratio was calculated.
Table 2 shows the results of pulse NMR measurements for Measurement Examples 18 to 23. In Table 2, T2A is the $^1$H spin-spin relaxation time T2 [ms] of dispersion A, and T2B is the $^1$H spin-spin relaxation time T2 [ms] of dispersion B.

[Table 2]

| measurement No. | powder | solvent | | powder : solvent | dispersion A | dispersion B | T2B/T2A | T2A/T2B |
|---|---|---|---|---|---|---|---|---|
| | | | SP | [mass ratio] | T2A | T2B | | |
| 18 | PA12 | NNP | 23 | 1 : 1.5 | 450 | 870 | 1.9 | 0.5 |
| 19 | PA11 | NNP | 23 | 1 : 1.5 | 1100 | 1300 | 1.2 | 0.8 |
| 20 | PA6 | NNP | 23 | 1 : 1.5 | 71 | 78 | 1.1 | 0.9 |
| 21 | PPS | NNP | 23 | 1 : 1.5 | 280 | 1380 | 4.9 | 0.2 |
| 22 | titanium | NNP | 23 | 1 : 0.2 | 27 | 33 | 1.2 | 0.8 |
| 23 | PA11 | NMP +ethyl lactate | - | 1 : 1.5 | 1100 | 1230 | 1.1 | 0.9 |

As shown in Measurement Examples 18 to 23, by using NMP (N-methyl-2-pyrrolidone) as the solvent, it was also possible to measure the relaxation time T2 of the reference dispersion A and the inspection dispersion B and to calculate the degradation degree of the modeling powder to be inspected. In addition, as shown in Measurement Example 23, by using a mixed solvent of NMP and ethyl lactate, it was also possible to measure the relaxation time T2 of the reference dispersion A and the inspection dispersion B and to calculate the degradation degree of the modeling powder to be inspected.

CORRELATION WITH OTHER MEASUREMENT METHODS

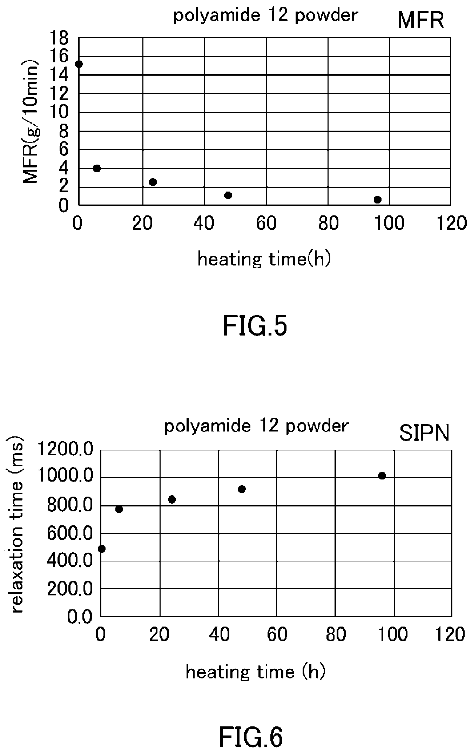

FIG. 5 is a graph showing the melt flow rate of PA12 with respect to heating time, and FIG. 6 is a graph showing the relaxation time T2 (NMP) of PA12 with respect to heating time. PA12 powder was heated at 175°C, and the melt flow rate and relaxation time T2 (NMP) were measured for the sample after a predetermined period of time. In the melt flow rate measurement, the melt flow rate decreased with the heating time, and in the relaxation time T2 measurement, the relaxation time T2 increased with the heating time. As can be seen by comparing the graph shown in FIG. 5 with the graph shown in FIG. 6, the relaxation time T2 measurement has a high correlation with the melt flow rate measurement. In addition, the thermal degradation of PA12 powder is thought to be due to an increase in the molecular weight inside the powder and the denaturation of the powder surface.

REFERENCE SIGNS LIST

10 regenerated-powder manufacturing device, 11 powder collection unit, 12 sieve mesh classification unit, 13 measurement unit, 14 powder supply unit, 15 mixing unit, 16 output unit, 17 control unit, 20 three-dimensional modeling device, 21 flattening roller, 30 powder tank, 31 powder, 40 modeling tank, 41 powder, 50 collection tank, 51 powder

**Claims**

1. A degradation-degree measuring method for modeling powder that

    uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder to be inspected is dispersed in the solvent and
    calculates the degradation degree of the modeling powder to be inspected based on the $^1$H spin-spin relaxation time $T2_1$ of the reference dispersion and the $^1$H spin-spin relaxation time $T2_2$ of the inspection dispersion.

2. The degradation-degree measuring method for modeling powder according to claim 1, wherein the modeling powder is a thermoplastic resin or a metal.

3. The degradation-degree measuring method for modeling powder according to claim 1 or 2, wherein the Hansen solubility parameter of the solvent is 14 $(J/cm^3)^{1/2}$ or more and 30 $(J/cm^3)^{1/2}$ or less.

4. A degradation-degree measuring device for modeling powder that uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder to be inspected is dispersed in the solvent and calculates the degradation degree of the modeling powder to be inspected based on the $^1$H spin-spin relaxation time $T2_1$ of the reference dispersion and the $^1$H spin-spin relaxation time $T2_2$ of the inspection dispersion.

5. The degradation-degree measuring device for modeling powder according to claim 4, wherein the modeling powder is a thermoplastic resin or a metal.

6. The degradation-degree measuring device for modeling powder according to claim 4 or 5, wherein the Hansen solubility parameter of the solvent is 14 $(J/cm^3)^{1/2}$ or more and 30 $(J/cm^3)^{1/2}$ or less.

7. A regenerated-modeling powder manufacturing method, comprising:

    measuring step of using a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculating the degradation degree of the modeling powder after use based on the $^1$H spin-spin relaxation time $T2_1$ of the reference dispersion and the $^1$H spin-spin relaxation time $T2_2$ of the inspection dispersion; and

a generation step of mixing the modeling powder after use and modeling powder before use based on the degradation degree of the modeling powder after use to generate regenerated-modeling powder.

8. A regenerated-molding powder manufacturing device, comprising:

measurement unit that uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculates the degradation degree of the modeling powder after use based on the $^1$H spin-spin relaxation time $T2_1$ of the reference dispersion and the $^1$H spin-spin relaxation time $T2_2$ of the inspection dispersion; and

a generation unit that generates regenerated-modeling powder by mixing the modeling powder after use and modeling powder before use based on the degradation degree of the modeling powder after use.

9. A three-dimensional modeled object manufacturing method, comprising:

measuring step of using a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculating the degradation degree of the modeling powder after use based on the $^1$H spin-spin relaxation time $T2_1$ of the reference dispersion and the $^1$H spin-spin relaxation time $T2_2$ of the inspection dispersion;

a generation step of mixing the modeling powder after use and modeling powder before use based on the degradation degree of the modeling powder after use to generate regenerated-modeling powder; and

a molding step of modeling a three-dimensional modeled object by additive manufacturing using the regenerated-modeling powder.

10. A three-dimensional modeled object manufacturing device, comprising:

measurement unit that uses a pulse NMR device to measure the $^1$H spin-spin relaxation time $T2_1$ of a reference dispersion in which a reference modeling powder is dispersed in a solvent and measure the $^1$H spin-spin relaxation time $T2_2$ of an inspection dispersion in which modeling powder after use to be inspected is dispersed in the solvent and calculates the degradation degree of the modeling powder after use based on the $^1$H spin-spin relaxation time $T2_1$ of the reference dispersion and the $^1$H spin-spin relaxation time $T2_2$ of the inspection dispersion;

a generation unit that generates regenerated-modeling powder by mixing the modeling powder after use and modeling powder before use based on the degradation degree of the modeling powder after use; and

a molding unit that models a three-dimensional modeled object by additive manufacturing using the regenerated-modeling powder.

11. A degradation-degree measuring device for modeling powder that uses a pulse NMR device to measure the $^1$H spin-spin relaxation time T2 of a dispersion in which a modeling powder is dispersed in a solvent and calculates the specific surface area of the modeling powder based on the $^1$H spin-spin relaxation time T2 of the dispersion and the $^1$H spin-spin relaxation time T2 of the solvent.

12. A degradation-degree measuring method for modeling powder that uses a pulse NMR device to measure the $^1$H spin-spin relaxation time T2 of a dispersion in which a modeling powder is dispersed in a solvent and calculates the specific surface area of the modeling powder based on the $^1$H spin-spin relaxation time T2 of the dispersion and the $^1$H spin-spin relaxation time T2 of the solvent.

13. The degradation-degree measuring method for modeling powder according to claim 12, wherein the modeling powder is a thermoplastic resin or a metal.

14. The degradation-degree measuring method for modeling powder according to claim 12 or 13, wherein the Hansen solubility parameter of the solvent is 14 $(J/cm^3)^{1/2}$ or more and 30 $(J/cm^3)^{1/2}$ or less.

**15.** The degradation-degree measuring method for modeling powder according to claim 12 or 13, wherein the $^1$H spin-spin relaxation time T2 of the solvent is 1,000 ms or more.

**16.** The degradation-degree measuring method for modeling powder according to claim 12 or 13, wherein the degradation degree of the modeling powder after use is calculated with reference to a specific surface area of modeling powder before use that has been measured and calculated in advance.

**17.** A regenerated-modeling powder manufacturing method, comprising:

a measurement step of sampling modeling powder after use, using a pulse NMR device to measure the $^1$H spin-spin relaxation time T2 of the dispersion in which the modeling powder after use is dispersed in a solvent and calculating the specific surface area of the modeling powder after use based on the $^1$H spin-spin relaxation time T2 of the dispersion and the $^1$H spin-spin relaxation time T2 of the solvent; and

a generation step of mixing the modeling powder after use and modeling powder before use based on the specific surface area of the modeling powder after use to generate regenerated-modeling powder.

**18.** A regenerated-modeling powder manufacturing device, comprising:

a measurement unit that samples modeling powder after use, uses a pulse NMR device to measure the $^1$H spin-spin relaxation time T2 of the dispersion in which the modeling powder after use is dispersed in a solvent and calculates the specific surface area of the modeling powder after use based on the $^1$H spin-spin relaxation time T2 of the dispersion and the $^1$H spin-spin relaxation time T2 of the solvent; and

a generation unit that mixes the modeling powder after use and modeling powder before use based on the specific surface area of the modeling powder after use to generate regenerated-modeling powder.

**19.** A three-dimensional modeled object manufacturing method, comprising:

a measurement step of sampling modeling powder after use, using a pulse NMR device to measure the $^1$H spin-spin relaxation time T2 of the dispersion in which the modeling powder after use is dispersed in a solvent and calculating the specific surface area of the modeling powder after use based on the $^1$H spin-spin relaxation time T2 of the dispersion and the $^1$H spin-spin relaxation time T2 of the solvent;

a generation step of mixing the modeling powder after use and modeling powder before use based on the specific surface area of the modeling powder after use to generate regenerated-modeling powder; and

a molding step of modeling a three-dimensional modeled object by additive manufacturing using the regenerated-modeling powder.

**20.** A three-dimensional modeled object manufacturing device, comprising:

a measurement unit that samples modeling powder after use, uses a pulse NMR device to measure the $^1$H spin-spin relaxation time T2 of the dispersion in which the modeling powder after use is dispersed in a solvent and calculates the specific surface area of the modeling powder after use based on the $^1$H spin-spin relaxation time T2 of the dispersion and the $^1$H spin-spin relaxation time T2 of the solvent;

a generation unit that mixes the modeling powder after use and modeling powder before use based on the specific surface area of the modeling powder after use to generate regenerated-modeling powder; and

a molding unit that models a three-dimensional modeled object by additive manufacturing using the regenerated-modeling powder.

10

FIG.1

START

COLLECT POWDER — S1

SIEVING — S2

PULSE NMR MEASUREMENT — S3

MIXING — S4

END

FIG.2

FIG.3

(A) POWDER SUPPLY

(B) FLATTENING

(C) RETURN

(D) MODELING

## FIG.4

FIG.5

FIG.6

## INTERNATIONAL SEARCH REPORT

| | International application No. |
|---|---|
| | **PCT/JP2023/039222** |

### A. CLASSIFICATION OF SUBJECT MATTER

***B29C 64/307***(2017.01)i
FI:   B29C64/307

According to International Patent Classification (IPC) or to both national classification and IPC

### B. FIELDS SEARCHED

Minimum documentation searched (classification system followed by classification symbols)

B29C64/307

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2021-141074 A (IONIC MATERIALS INC.) 16 September 2021 (2021-09-16)<br>entire text, all drawings | 1-20 |
| A | JP 2016-216583 A (RICOH CO., LTD.) 22 December 2016 (2016-12-22)<br>entire text, all drawings | 1-20 |

☐ Further documents are listed in the continuation of Box C.     ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br><br>**17 January 2024** | Date of mailing of the international search report<br><br>**30 January 2024** |
| Name and mailing address of the ISA/JP<br><br>**Japan Patent Office (ISA/JP)**<br>**3-4-3 Kasumigaseki, Chiyoda-ku, Tokyo 100-8915**<br>**Japan** | Authorized officer<br><br><br><br>Telephone No. |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| JP | 2021-141074 | A | 16 September 2021 | WO | 2016/182884 | A1 | |
| JP | 2016-216583 | A | 22 December 2016 | (Family: none) | | | |

**EP 4 613 460 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022040669 W
- JP 2008050671 A